# EUROPEAN PATENT APPLICATION

(11) **EP 4 783 777 A1**
(43) Date of publication of application: **29.07.2026**
(21) Application number: 24868495.3
(22) Date of filing: 23.08.2024
(51) Int. Cl.: H10F 10/161

(54) **TANDEM TYPE SILICON/PEROVSKITE HETEROJUNCTION SOLAR CELL AND MANUFACTURING METHOD THEREFOR**

(30) Priority: 18.09.2023 KR 20230123875
(71) Applicant: Hanwha Solutions Corporation, Jung-gu Seoul 04541 (KR)
(72) Inventor: YANG, Woon Seok, Seoul 04541 (KR); HONG, Jung Yun, Seoul 04541 (KR)
(74) Representative: Mooser, Sebastian Thomas
(86) International application number: PCT/KR2024/012600
(87) International publication number: WO 2025/063516

(57) **Abstract**

The present invention relates to a tandem silicon/perovskite heterojunction solar cell in which a benzylhydrazine oxalate salt is introduced as an additive into a perovskite light-absorbing layer, and a manufacturing method therefor.

## Description

### TECHNICAL FIELD

The present invention relates to a tandem silicon/perovskite heterojunction solar cell in which a benzylhydrazine oxalate salt is introduced as an additive into a perovskite light-absorbing layer, and a manufacturing method therefor.

### BACKGROUND ART

In order to solve the global environmental problems caused by the depletion of fossil fuels and the usage thereof, research on renewable and clean alternative energy sources, such as solar energy, wind power and hydropower, is being actively conducted.

Among these, interest in solar cells that directly convert electrical energy from sunlight is increasing significantly. Here, a solar cell refers to a cell that generates current-voltage by utilizing the photovoltaic effect that generates electrons and holes by absorbing light energy from sunlight.

Currently, it is possible to manufacture n-p diode-type silicon (Si) single crystal-based solar cells with a light energy conversion efficiency of over 20%, and they are actually being used for solar power generation, and there are also solar cells using compound semiconductors such as gallium arsenide (GaAs) with an even higher conversion efficiency. However, these inorganic semiconductor-based solar cells require highly purified materials to achieve high efficiency, and thus, a lot of energy is consumed in refining the raw materials, and expensive process equipment is required in the process of using the raw materials to make a single crystal or thin film, which limits the cost of lowering the manufacturing cost of solar cells, and this has been an obstacle to large-scale utilization.

Accordingly, in order to manufacture solar cells at low cost, it is necessary to drastically reduce the cost of materials or manufacturing processes used as core elements of solar cells, and research is being conducted on perovskite solar cells that can be manufactured by using low-cost materials and processes as an alternative to inorganic semiconductor-based solar cells.

Recently, perovskite solar cells using (NH₃CH₃)PbX₃ (X = I, Br, Cl), which is a halogen compound with a perovskite structure, as a photoactive agent have been developed, and research is being conducted toward commercialization. The general structural formula of the perovskite structure is the ABX₃ structure, where an anion is located in the X position, a large cation is located in the A position, and a small cation is located in the B position.

Perovskite solar cells, which are organometallic halide compounds with the molecular formula (CH₃NH₃)PbX₃, were first used as a photoactive material in solar cells in 2009. Since then, since solid-state perovskite solar cells with the current structure were developed in 2012, rapid improvements in efficiency have been made. Conventional perovskite solar cells use metal oxides as the electron transport layer and also use metal oxides as the hole transport layer (HTL), but organic or polymer materials such as spiro-OMETAD can also be used. That is, a porous film or thin film of metal oxide is produced as the electron transport layer/hole transport layer on a transparent electrode such as FTO/ITO, and the perovskite material is coated. Afterwards, a porous film or thin film of metal oxide is produced as the hole transport layer/electron transport layer, and then, an electrode layer such as gold (Au) or silver (Ag) is deposited.

Perovskite solar cells, which are organometallic halide compounds with the molecular formula (CH₃NH₃)PbX₃, use halide ions such as I, Br and Cl in the molecular formula, where X is a halide ion such as I, Br, or Cl. In this case, the excess halide that does not participate in the formation of the perovskite crystal phase exists in the form of ionic defects and is not fixed to the perovskite crystal, but can escape from the crystal in the form of halide combined with hydrogen or a light cation, thereby having high diffusivity. Therefore, after the fabrication of Si/perovskite tandem solar cells, halide ions easily diffuse into the surrounding layers without restriction due to heating, light irradiation or electrical external factors that are essential in the subsequent module process.

Meanwhile, the upper perovskite thin film applied to the tandem solar cell is configured with a band gap of 1.60 to 1.70 eV for current matching with the lower silicon solar cell in a two-terminal structure, and the band gap of the perovskite can be controlled depending on the ratio of ABX₃ constituting the perovskite. Among the composition materials of the perovskite thin film for configuring the tandem solar cell, materials corresponding to the A site include MA⁺ (methyl ammonium cation), FA⁺ (formamidinium cation), Cs⁺ (cesium cation) and the like, and are composed of a combination of these.

Recently, due to the thermal stability problem of MA⁺, a perovskite layer that does not include MA⁺ is being developed. The material corresponding to the B site is Pb²⁺ (lead cation), the material corresponding to the X site is Cl⁻ (chloride anion), Br⁻ (bromide anion), I⁻ (iodide anion) and the like, and the composition of perovskite composed of a combination of these is generally utilized as the upper layer of a tandem solar cell.

Methods for making perovskite thin films are largely categorized into coating (=solution) process and deposition process, and the deposition process has the disadvantage of requiring vacuum equipment, and thus, the coating (=solution) process, which is a simpler method, is the main method.

In order to form a conventional perovskite thin film, perovskite materials are put into a solvent to form a precursor state, which is a solution state. In this case, the solvents mainly used are DMF, 2-ME and the like, and NMP, DMPU, HMPA, THTO, and the like are used as additive solvents. When the solutions are stored here, I⁻ ions are easily reduced to I₂/I₃⁻, which deteriorates the performance of silicon/perovskite tandem solar cells in the long term.

Meanwhile, in the coating (=solution), a process of crystallizing into a thin film through heat treatment in a solution state is essential to produce a perovskite layer. However, in this process, perfect crystallization is not achieved without the loss of composition, and defects inevitably occur during the heat treatment. In addition, rapid crystallization is formed without creating a large grain size, and thus, many grain boundaries are created. These can act as recombination centers for charge movement, which becomes an obstacle to creating good performance.

In particular, when it diffuses into a metal electrode such as gold (Au) or silver (Ag) in a Si/perovskite tandem solar cell, it not only corrodes the interface between the transparent electrode and the metal electrode, increasing the interfacial contact resistance, but also causes the metal ion leakage into the solar cell due to the corrosion of the metal electrode, which reduces the performance of the solar cell.

### DISCLOSURE

### TECHNICAL PROBLEM

The present invention has been devised to overcome the above-described problems, and is directed to providing a tandem silicon/perovskite heterojunction solar cell, which can increase charge collection capability by reducing charge recombination in a perovskite light-absorbing layer by introducing a benzylhydrazine oxalate salt as an additive into the perovskite light-absorbing layer, and can also reduce the deterioration of a solar cell, thereby exhibiting improved performance in terms of stability, and a manufacturing method therefor.

### TECHNICAL SOLUTION

In order to solve the above-described problems, the tandem silicon/perovskite heterojunction solar cell of the present invention is a heterojunction solar cell in which a solar cell, a transparent conductive layer, a hole transport layer, a perovskite light-absorbing layer, an electron transport layer, a transparent electrode and a metal electrode are sequentially stacked.

In a preferred embodiment of the present invention, the perovskite light-absorbing layer may include a perovskite material represented by Chemical Formula 1 below and a benzylhydrazine oxalate salt:

[Chemical Formula 1] FACsPbX₃

wherein in Chemical Formula 1 above, X is a monovalent anion.

In a preferred embodiment of the present invention, the perovskite light-absorbing layer may include the perovskite material represented by Chemical Formula 1 above and the benzylhydrazine oxalate salt in a weight ratio of 1:0.0001 to 0.002.

In a preferred embodiment of the present invention, the perovskite light-absorbing layer may have an average thickness of 450 to 700 nm.

In a preferred embodiment of the present invention, the tandem silicon/perovskite heterojunction solar cell may further include a first interface layer between the hole transport layer and the perovskite light-absorbing layer.

In a preferred embodiment of the present invention, the first interface layer may include a P-type organic molecule SAM interface coating agent.

In a preferred embodiment of the present invention, the first interface layer may have a thickness of 0.5 nm to 10 nm.

In a preferred embodiment of the present invention, the tandem silicon/perovskite heterojunction solar cell may further include a second interface layer between the perovskite light-absorbing layer and the electron transport layer.

In a preferred embodiment of the present invention, the second interface layer may include one or more selected from lithium fluoride (LiF), magnesium fluoride (MgF₂), cesium fluoride (CsF), sodium fluoride (NaF), potassium fluoride (KF), aluminum fluoride (AlF₃) and calcium fluoride (CaF₂).

In a preferred embodiment of the present invention, the second interface layer may have a thickness of 0.5 nm to 10 nm.

In a preferred embodiment of the present invention, the tandem silicon/perovskite heterojunction solar cell may further include an intermediate layer between the second interface layer and the electron transport layer.

In a preferred embodiment of the present invention, the intermediate layer may include a fullerene-series organic material.

Meanwhile, the method for manufacturing a tandem silicon/perovskite heterojunction solar cell according to the present invention may include step 1 of sequentially stacking a solar cell, a transparent conductive layer, a hole transport layer and a first interface layer; step 2 of forming a perovskite light-absorbing layer on the first interface layer through a coating method; and step 3 of sequentially forming a second interface layer, an intermediate layer, an electron transport layer, a transparent electrode and a metal electrode on the perovskite light-absorbing layer,

In a preferred embodiment of the present invention, the perovskite light-absorbing layer may include a perovskite material represented by Chemical Formula 1 below and a benzylhydrazine oxalate salt:

[Chemical Formula 1] FACsPbX₃

wherein in Chemical Formula 1 above, X is a monovalent anion.

In a preferred embodiment of the present invention, the coating method may be a gravure coating method, a bar coating method, a printing method, a spray coating method, a spin coating method, a blade coating method, a dip method or a die coat method.

In a preferred embodiment of the present invention, in the perovskite light-absorbing layer, the perovskite material represented by Chemical Formula 1 above and the benzylhydrazine oxalate may mixed in a weight ratio of 1:0.0001 to 0.002.

In a preferred embodiment of the present invention, the first interface layer may be formed by including step (1) of heating the hole transport layer; step (2) of coating a P-type organic molecule SAM interfacial coating agent on a heated hole transport layer; and step (3) of drying a coated P-type organic molecule SAM interfacial coating agent to form a first interfacial layer.

### ADVANTAGEOUS EFFECTS

The tandem silicon/perovskite heterojunction solar cell of the present invention and manufacturing method therefor can reduce the formation of traps by reducing I₂/I₃⁻ to I⁻ by introducing a benzylhydrazine oxalate as an additive when forming a perovskite light-absorbing layer.

In addition, the tandem silicon/perovskite heterojunction solar cell of the present invention and manufacturing method therefor can delay the growth of nuclei during crystal growth of a perovskite light-absorbing layer, thereby allowing better growth into a single grain.

In addition, the tandem silicon/perovskite heterojunction solar cell of the present invention and manufacturing method therefor can more effectively alleviate defects generated by substituting halide defects with (C₂O₄)²⁻.

### MODES OF THE INVENTION

Hereinafter, the present invention will be described in more detail.

In order to form a conventional perovskite thin film, perovskite materials are put into a solvent to form a precursor state, which is a solution state. In this case, the solvents mainly used are DMF, 2-ME and the like, and there are NMP, DMPU, HMPA, THTO and the like as additive solvents. When the solutions are stored here, I⁻ ions are easily reduced to I₂/I₃⁻, which deteriorates the performance of silicon/perovskite tandem solar cells in the long term.

Meanwhile, in the coating (=solution), a process of crystallizing into a thin film through heat treatment in a solution state is essential to produce a perovskite layer. However, in this process, perfect crystallization is not achieved without the loss of composition, and defects inevitably occur during the heat treatment. In addition, rapid crystallization is formed without creating a large grain size, and thus, many grain boundaries are created. These can act as recombination centers for charge movement, which becomes an obstacle to creating good performance.

In particular, when it diffuses into a metal electrode such as gold (Au) or silver (Ag) in a Si/perovskite tandem solar cell, it not only corrodes the interface between the transparent electrode and the metal electrode, increasing the interfacial contact resistance, but also causes the metal ion leakage into the solar cell due to the corrosion of the metal electrode, which reduces the performance of the solar cell.

Accordingly, the present invention relates to a tandem silicon/perovskite heterojunction solar cell, which can increase charge collection capability by reducing charge recombination in a perovskite light-absorbing layer by introducing a benzylhydrazine oxalate salt as an additive into the perovskite light-absorbing layer, and can also reduce the deterioration of a solar cell, thereby exhibiting improved performance in terms of stability.

The tandem silicon/perovskite heterojunction solar cell of the present invention may be a heterojunction solar cell having a structure in which a solar cell, a transparent conductive layer, a hole transport layer, a perovskite light-absorbing layer, an electron transport layer, a transparent electrode and a metal electrode are sequentially stacked.

In addition, the tandem silicon/perovskite heterojunction solar cell of the present invention may further include a first interfacial layer between the hole transport layer and the perovskite light-absorbing layer. In this case, the tandem silicon/perovskite heterojunction solar cell of the present invention may be a heterojunction solar cell having a structure in which a solar cell, a transparent conductive layer, a hole transport layer, a first interfacial layer, a perovskite light-absorbing layer, an electron transport layer, a transparent electrode and a metal electrode are sequentially stacked.

In addition, the tandem silicon/perovskite heterojunction solar cell of the present invention may further include a second interfacial layer between the perovskite light-absorbing layer and the electron transport layer. In this case, the tandem silicon/perovskite heterojunction solar cell of the present invention may be a heterojunction solar cell having a structure in which a solar cell, a transparent conductive layer, a hole transport layer, a perovskite light-absorbing layer, a second interfacial layer, an electron transport layer, a transparent electrode and a metal electrode are sequentially stacked.

Meanwhile, the tandem silicon/perovskite heterojunction solar cell of the present invention may be a heterojunction solar cell having a structure in which a solar cell, a transparent conductive layer, a hole transport layer, a first interface layer, a perovskite light-absorbing layer, a second interface layer, an electron transport layer, a transparent electrode and a metal electrode are sequentially stacked.

In addition, the tandem silicon/perovskite heterojunction solar cell of the present invention may further include an intermediate layer between the second interface layer and the electron transport layer. In this case, the tandem silicon/perovskite heterojunction solar cell of the present invention may be a heterojunction solar cell having a structure in which a solar cell, a transparent conductive layer, a hole transport layer, a first interface layer, a perovskite light-absorbing layer, a second interface layer, an intermediate layer, an electron transport layer, a transparent electrode and a metal electrode are sequentially stacked.

The solar cell may be a polycrystalline silicon solar cell, a crystalline silicon solar cell, a perovskite solar cell, a gallium arsenide (GaAs) solar cell, a cadmium telluride (CdTe) solar cell, a CIGS (CuInGaSe) solar cell, a CZTS (Cu₂ZnSnS₄) solar cell, an organic solar cell, a fluorine-sensitized solar cell or a group III-V compound solar cell.

In addition, there is no separate limitation on the thickness of the solar cell, but it may preferably have a thickness of 140 to 250 µm, and more preferably 160 to 200 µm.

The transparent conductive layer is a layer that induces the recombination of electrons and holes generated in the solar cell and the perovskite light-absorbing layer described later, and may be a transparent thin film on which ITO (Indium Tin Oxide), FTO (Fluorine doped Tin Oxide), ATO (Sb₂O₃ doped Tin Oxide), GTO (Gallium doped Tin Oxide), ZTO (tin doped zinc oxide), ZTO:Ga (gallium doped ZTO), IGZO (Indium gallium zinc oxide), IZO (Indium doped zinc oxide) or AZO (Aluminum doped zinc oxide) is deposited.

In addition, as an example of forming a transparent conductive layer, when using a silicon solar cell doped with n or p-type impurities as a solar cell, the silicon solar cell doped with n or p type impurities may be treated with hydrofluoric acid to remove the SiOx oxide film, and then, the remaining hydrofluoric acid is removed by using ultrapure water. Then, a transparent conductive layer may be formed on the silicon solar cell from which the oxide film has been removed through a sputtering process.

In addition, the thickness of the transparent conductive layer is not particularly limited, but may preferably have a thickness of 5 nm to 50 nm, and more preferably 15 nm to 25 nm.

The hole transport layer (HTL) is a layer that transports holes formed in the perovskite light-absorbing layer described below while blocking the movement of electrons, and may include an inorganic and/or organic hole transport material.

In this case, the inorganic hole transport material may include one or more selected from nickel oxide (NiOx), CuSCN, CuCrO₂, CuI, MoO and V₂O₅.

In addition, the organic hole transport material may include one or more selected from a carbazole derivative, a polyarylalkane derivative, a phenylenediamine derivative, an arylamine derivative, an amino-substituted chalcone derivative, a styrylanthracene derivative, a fluorene derivative, a hydrazone derivative, a stilbene derivative, a silazane derivative, an aromatic tertiary amine compound, a styrylamine compound, an aromatic dimethylidine compound, a porphyrin compound, a phthalocyanine compound, a polythiophene derivative, a polypyrrole derivative, a polyparaphenylenevinylene derivative, pentacene, coumarin 6 (coumarin 6, 3-(2-benzothiazolyl)-7-(diethylamino)coumarin), ZnPC (zinc phthalocyanine), CuPC (copper phthalocyanine), TiOPC (titanium oxide phthalocyanine), Spiro-MeOTAD(2,2',7,7'-tetrakis(N,N-p-dimethoxyphenylamino)-9,9'-spirobifluorene), F16CuPC (copper(II) 1,2,3,4,8,9,10,11,15,16,17,18,22,23,24,25-hexadecafluoro-29H,31H-phthalocyanine), SubPc (boron subphthalocyanine chloride) and N3 (cis-di(thiocyanato)-bis(2,2'-bipyridyl-4,4'-dicarboxylic acid)-ruthenium(II), P3HT(poly[3-hexylthiophene]), MDMO-PPV (poly[2-methoxy-5-(3',7'-dimethyloctyloxyl)]-1,4-phenylene vinylene), MEH-PPV (poly[2-methoxy-5-(2''-ethylhexyloxy)-p-phenylene vinylene]), P3OT (poly(3-octyl thiophene)), POT (poly(octyl thiophene)), P3DT (poly(3-decyl thiophene)), P3DDT (poly(3-dodecyl thiophene), PPV (poly(p-phenylene vinylene)), TFB (poly(9,9'-dioctylfluorene-co-N-(4-butylphenyl)diphenyl amine), polyaniline, Spiro-MeOTAD ([2,22',7,77'-tetrkis (N,N-di-pmethoxyphenyl amine)-9,9,9'-spirobi fluorine]), PCPDTBT (Poly[2,1,3-benzothiadiazole-4,7-diyl[4,4-bis(2-ethylhexyl-4H-cyclopenta [2,1-b:3,4-b']dithiophene-2,6-diyl]], Si-PCPDTBT (poly[(4,4'-bis(2-ethylhexyl)dithieno[3,2-b:2',3'-d]silole)-2,6-diyl-alt-(2,1,3-benzothiadiazole)-4,7-diyl]), PBDTTPD (poly((4,8-diethylhexyloxyl), PFDTBT (poly[2,7-(9-(2-ethylhexyl)-9-hexyl-fluorene)-alt-5,5-(4', 7, -di-2-thienyl-2',1', 3'-benzothiadiazole)]), PFO-DBT (poly[2,7-.9,9-(dioctyl-fluorene)-alt-5,5-(4',7'-di-2-.thienyl-2', 1', 3'-benzothiadiazole)]), PSiFDTBT (poly[(2,7-dioctylsilafluorene)-2,7-diyl-alt-(4,7-bis(2-thienyl)-2,1,3-benzothiadiazole)-5,5'-diyl]), PCDTBT (Poly [[9-(1-octylnonyl)-9H-carbazole-2,7-diyl] -2,5-thiophenediyl-2,1,3-benzothiadiazole-4,7-diyl-2,5-thiophenediyl]), PFB (poly(9,9'-dioctylfluorene-co-bis(N,N'-(4,butylphenyl))bis(N,N'-phenyl-1,4-phenylene)diamine), F8BT (poly(9,9'-dioctylfluorene-cobenzothiadiazole), PEDOT (poly(3,4-ethylenedioxythiophene)), PEDOT:PSS, poly(3,4-ethylenedioxythiophene) poly(styrenesulfonate), PTAA (poly(triarylamine)), 2-PACz, MeO-2PACz, Br-2PACz and Me-4PACz.

In addition, methods for forming the hole transport layer include a coating method and a vacuum deposition method, and the coating method may be a gravure coating method, a bar coating method, a printing method, a spray method, a spin coating method, a blade coating method, a dip method and a die coat method.

In addition, the thickness of the hole transport layer is not particularly limited, but may preferably have a thickness of 5 nm to 40 nm, and more preferably 10 nm to 30 nm.

The first interface layer plays a role in effectively transporting holes by controlling the work function of the hole transport layer, and may include a P-type organic molecule SAM interface coating agent. The P-type organic molecule SAM interface coating agent may include a PACz-based compound and a solvent.

The PACz-series compound may include one or more selected from 2-PACz (2-(9H-Carbazol-9-yl)ethyl]phosphonic Acid), MeO-2PACz, Br-2PACz, Me-4PACz, MeO-4PACz, 6-PACz and Me-6PACz. In addition, the P-type organic molecule SAM interfacial coating agent may include the PACz series compound at a concentration of 0.30 mg/mL to 10.00 mg/mL.

The solvent may include one or more selected from methanol, ethanol, 1-propanol and 1-butanol.

In addition, the first interface layer may have a thickness of 0.5 nm to 10 nm, and preferably 2 to 8 nm.

In addition, the first interface layer may have a surface roughness RMS (Root-mean square) of 4.50 to 80.00 nm, and preferably 5.00 to 50.00 nm.

In addition, as a method for forming the first interface layer, examples thereof include a coating method and a vacuum deposition method, and as a coating method, examples thereof include a gravure coating method, a bar coating method, a printing method, a spray method, a spin coating method, a blade coating method, a dip method and a die coat method.

The perovskite light-absorbing layer may include a perovskite material represented by Chemical Formula 1 below and a benzylhydrazine oxalate salt.

[Chemical Formula 1] FACsPbX₃

In Chemical Formula 1 above, X is a monovalent anion. Specifically, X may include one or more monovalent anions selected from iodide, bromide, chloride, fluoride, thiocyanate, cyanate, selenocyanate, formate and acetate.

As a preferred example, X may be IₓBr₃₋ₓ (0≤x≤3). In addition, as a preferred embodiment of Chemical Formula 1 above, it may be FACsPbIₓBr₃₋ₓ (0≤x≤3).

Specifically, the perovskite light-absorbing layer may include the perovskite material represented by Chemical Formula 1 above and the benzylhydrazine oxalate in a weight ratio of 1:0.0001 to 0.002, preferably 1:0.0003 to 0.0014, and more preferably 1:0.0004 to 0.0008. If the weight ratio is less than 1:0.0001, there may be a problem that the expected effect is minimal, and if it is more than 1:0.002, there may be a problem that it acts as a defect.

The perovskite light-absorbing layer may be formed by blade coating or spin coating a solution including the perovskite material represented by Chemical Formula 1 above and the benzylhydrazine oxalate salt on one surface of the first interfacial layer, and then heat treating. In addition, non-limiting examples of methods for forming the perovskite light-absorbing layer include a coating method and/or a vacuum deposition method, and the coating method may be a gravure coating method, a bar coating method, a printing method, a spray coating method, a spin coating method, a blade coating method, a dip method or a die coat method.

In addition, the thickness of the perovskite light-absorbing layer is not particularly limited, but may preferably have a thickness of 100 to 800 nm, more preferably 450 to 700 nm, and even more preferably 550 to 700 nm.

The second interface layer plays roles in reducing defects in the perovskite, blocking external deterioration factors (such as moisture) to increase stability, and effectively transferring electrons to the electron transport layer by controlling the work function.

In addition, the second interface layer may have a thickness of 0.5 nm to 10 nm, and preferably 2 to 8 nm.

In addition, the second interface layer may have a surface roughness RMS (Root-mean square) of 4.50 to 80.00 nm, and preferably 5.00 to 50.00 nm.

In addition, methods for forming the second interface layer include a coating method and a vacuum deposition method, and the coating method may be a gravure coating method, a bar coating method, a printing method, a spray method, a spin coating method, a blade coating method, a dip method and a die coat method.

In addition, the second interfacial layer may include one or more selected from lithium fluoride (LiF), magnesium fluoride (MgF₂), cesium fluoride (CsF), sodium fluoride (NaF), potassium fluoride (KF), aluminum fluoride (AlF₃) and calcium fluoride (CaF₂).

The intermediate layer may include a fullerene-based organic material. In this case, the fullerene-based organic material may include one or more selected from C₆₀, C₇₀, PC60BM and PC70BM, and preferably C₆₀. The methods for forming the intermediate layer include a coating method and a vacuum deposition method, and examples of the coating method include a gravure coating method, a bar coating method, a printing method, a spray method, a spin coating method, a blade coating method, a dip method and a die coat method.

In addition, the intermediate layer may have a thickness of 2 nm to 20 nm, and preferably 10 to 15 nm.

The electron transport layer (ETL) is a layer that transports electrons formed in the perovskite light-absorbing layer while blocking the movement of holes, and may include one or more selected from tin oxide (SnO₂), titanium dioxide (TiO₂), zinc oxide (ZnO), barium tin oxide (BaSnO₃), niobium hydroxide (NbOH) and niobium pentoxide (Nb₂O₅).

In addition, methods for forming the electron transport layer include a coating method and/or a vacuum deposition method, and examples of the coating method include a gravure coating method, a bar coating method, a printing method, a spray method, a spin coating method, a blade coating method, a dip method and a die coat method.

In addition, the thickness of the electron transport layer is not particularly limited, but may preferably have a thickness of 5 to 40 nm, and more preferably 15 to 35 nm.

A transparent electrode may be formed on the electron transport layer through a deposition process. In this case, the deposition may be performed by a general deposition process used in the art, and preferably, the deposition process may be performed by using a sputtering method under the conditions of a process temperature of 100°C or less, an RF power of 100 to 300 W, a process pressure of 1 to 3 mTorr, and an argon (Ar) flow of 10 to 40 sccm.

In addition, the transparent electrode may be a transparent thin film on which ITO (Indium Tin Oxide), FTO (Fluorine doped Tin Oxide), ATO (Sb ₂ O ₃ doped Tin Oxide), GTO (Gallium doped Tin Oxide), ZTO (tin doped zinc oxide), ZTO:Ga (gallium doped ZTO), IGZO (Indium gallium zinc oxide), IZO (Indium doped zinc oxide) or AZO (Aluminum doped zinc oxide) is deposited.

In addition, the thickness of the transparent electrode is not particularly limited, but may preferably have a thickness of 50 to 200 nm, and more preferably 50 to 140 nm.

A metal electrode may be formed by patterning a metal material on a transparent electrode. Specifically, the patterning process is largely composed of deposition, lithography and etching. A metal electrode may be formed on a transparent electrode by spreading a metal material in the form of a thin film on one surface of a substrate, printing a pattern by lithography, and then removing unnecessary portions.

In this case, the metal material may include one or more selected from Pt, Au, Ni, Cu, Ag, In, Ru, Pd, Rh, Ir, Os, C and a conductive polymer.

In addition, there is no separate limitation on the thickness of the metal electrode, but it may preferably have a thickness of 50 nm to 2.5 µm.

Meanwhile, the method for manufacturing a tandem silicon/perovskite heterojunction solar cell according to the present invention includes steps 1 to 3.

First of all, step 1 of the method for manufacturing a tandem silicon/perovskite heterojunction solar cell may be to sequentially stack a solar cell, a transparent conductive layer, a hole transport layer and a first interface layer. In this case, the solar cell, the transparent conductive layer, the hole transport layer and the first interface layer are the same as described above.

Specifically, a transparent conductive layer may be formed on a solar cell through a sputtering process. In addition, a hole transport layer may be formed on the transparent conductive layer through a coating method, a vacuum deposition method and the like.

Furthermore, the first interface layer may be formed by including step (1) of heating a hole transport layer, step (2) of coating a P-type organic molecule SAM interface coating agent on a heated hole transport layer, and step (3) of drying a coated P-type organic molecule SAM interface coating agent to form the first interface layer.

The heating of step (1) may be performed such that the hole transport layer is heated to 40 to 100°C, preferably 40 to 80°C, more preferably 45 to 70°C, and even more preferably 50 to 60°C.

The coating of step (2) may be performed by blade coating, slot die coating, bar coating, gravure coating, spray coating, inkjet printing or screen printing, and preferably, blade coating, slot die coating or bar coating may be performed.

The P-type organic molecule SAM interface coating agent of step (2) includes a PACz-based compound and a solvent, and the PACz-based compound may be included at a concentration of 0.30 mg/mL to 10.00 mg/mL. In this case, if the concentration of the PACz-based compound is less than 0.30 mg/mL, the organic molecule SAM layer may not be sufficiently formed, which may cause a problem in that the solar cell efficiency is not increased, and if the concentration of the PACz-based compound is more than 10.00 mg/mL, the film may be coated too thickly.

In addition, the PACz compound may include one or more selected from 2-PACz (2-(9H-Carbazol-9-yl)ethyl]phosphonic acid), MeO-2PACz, Br-2PACz, Me-4PACz, MeO-4PACz, 6-PACz and Me-6PACz. In addition, the solvent of the P-type organic molecule SAM interfacial coating agent may include one or more selected from methanol, ethanol, 1-propanol and 1-butanol.

Step (3) is a process for drying the coating agent coated in step (2), which may be performed by a natural drying, oven heat treatment or hot plate heat treatment process, but it is preferable to perform natural drying without a separate heat treatment.

Next, step 2 of the method for manufacturing a tandem silicon/perovskite heterojunction solar cell may form a perovskite light-absorbing layer on the first interfacial layer through a coating method.

The formed perovskite light-absorbing layer may include a perovskite material represented by Chemical Formula 1 below and a benzylhydrazine oxalate salt.

[Chemical Formula 1] FACsPbX₃

In Chemical Formula 1 above, X is a monovalent anion.

Specifically, in the perovskite light-absorbing layer, the perovskite material represented by Chemical Formula 1 above and the benzylhydrazine oxalate salt may be mixed in a weight ratio of 1:0.0001 to 0.002, preferably 1:0.0003 to 0.0014, and more preferably 1:0.0004 to 0.0008.

The perovskite light-absorbing layer may be formed by blade coating or spin coating a solution including the perovskite material represented by Chemical Formula 1 above and the benzylhydrazine oxalate on one surface of the first interfacial layer, and then heat treating. In addition, non-limiting examples of methods for forming the perovskite light-absorbing layer include a coating method and/or a vacuum deposition method, and the coating method may be a gravure coating method, a bar coating method, a printing method, a spray coating method, a spin coating method, a blade coating method, a dip method or a die coat method.

Finally, step 3 of the method for manufacturing a tandem silicon/perovskite heterojunction solar cell may sequentially form a second interface layer, an intermediate layer, an electron transport layer, a transparent electrode and a metal electrode on the perovskite light-absorbing layer. In this case, the second interface layer, the intermediate layer, the electron transport layer, the transparent electrode and the metal electrode are the same as described above.

The second interface layer may be formed on the perovskite light-absorbing layer by a coating method and/or a deposition method (vacuum deposition, thermal deposition, vacuum thermal deposition, etc.), the intermediate layer may be formed on the second interface layer by a coating method and/or a deposition method (vacuum deposition, thermal deposition, vacuum thermal deposition, etc.), the electron transport layer may be formed on the intermediate layer by a coating method and/or a vacuum deposition method, and the transparent electrode may be formed on the electron transport layer by a deposition process. In addition, the metal electrode may be formed by patterning a metal material on the transparent electrode. In this case, the coating method may be a gravure coating method, a bar coating method, a printing method, a spray coating method, a spin coating method, a blade coating method, a dip method or a die coat method.

Hereinafter, the present invention will be described more specifically through examples, but the following examples do not limit the scope of the present invention, and should be interpreted as helping to understand the present invention.

### Preparation Example 1: Preparation of P-type organic molecule SAM interface coating agent

A P-type organic molecule SAM interfacial coating agent was prepared by mixing 2-PACz (2-(9H-Carbazol-9-yl)ethyl]phosphonic Acid) at a concentration of 2.75 mg/mL in a 99% pure ethanol solvent.

### Example 1: Manufacture of tandem silicon/perovskite heterojunction solar cell

(1) A silicon solar cell (thickness: 180 µm) doped with n or p-type impurities was prepared, and a SiOx oxide film was removed by hydrofluoric acid treatment. Then, the remaining hydrofluoric acid was removed by using ultrapure water. A 20 nm thick transparent conductive layer (ITO) was formed on the silicon solar cell from which the oxide film was removed through a sputtering process (process conditions: process temperature 25 to 45°C, RF power 100 to 250 W, process pressure 2.2 to 2.4 mTorr, argon flow rate 10 to 40 sccm).
(2) Next, a 20 nm thick hole transport layer (NiOx) was formed on the transparent conductive layer through sputtering vacuum deposition.
(3) Next, the hole transport layer was heated to a temperature of 50°C, and then, the P-type organic molecule SAM interfacial coating agent prepared in Preparation Example 1 was blade-coated on the heated hole transport layer to an average thickness of 3.1 nm at a blade coating speed of 10 mm/s, followed by natural drying, thereby forming a first interfacial layer through the blade coating method.
(4) Next, a precursor solution prepared by dissolving a perovskite material represented by Chemical Formula 1-1 below and a benzylhydrazine oxalate salt in a mixed solution including dimethylformamide (DMF) and dimethylpropyleneurea (N,N'-Dimethylpropyleneurea (DMPU)) was blade-coated on the first interfacial layer, followed by heat treatment at 150°C for 10 minutes and then again at 115°C for 20 minutes, thereby forming a perovskite light-absorbing layer including a benzylhydrazine oxalate salt with a thickness of 600 nm and having a perovskite crystal structure. In this case, the precursor solution included a perovskite material represented by Chemical Formula 1-1 below and a benzylhydrazine oxalate salt in a weight ratio of 1:0.0005.

   [Chemical Formula 1-1] FACsPb(IₐBr_{b})₃

   In Chemical Formula 1-1 above, a and b have a molar ratio of 8:2.
(5) Next, a second interface layer (LiF) with an average thickness of 3.1 nm was formed on the perovskite light-absorbing layer through vacuum thermal evaporation.
(6) Next, C₆₀ fullerene was deposited on the second interface layer using a thermal evaporation method to form an intermediate layer with an average thickness of 13 nm.
(7) Next, a SnO₂ nano colloidal solution was spin-coated on the intermediate layer to form an electron transport layer (SnO₂) with a thickness of 15 nm.
(8) Next, a transparent electrode (ITO) with a thickness of 70 nm was formed on the electron transport layer through a sputtering process (process conditions: process temperature 95 to 98°C, RF power 100 to 200 W, process pressure 2.2 to 2.4 mTorr, argon flow rate 10 to 40 sccm).
(9) Finally, silver (Ag) was deposited on the transparent electrode at a pressure of 1×10⁻⁷ torr with a thickness of 100 nm to form a metal electrode, thereby manufacturing a tandem silicon/perovskite heterojunction solar cell in which a silicon solar cell, a transparent conductive layer, a hole transport layer, a first interface layer, a perovskite light-absorbing layer, a second interface layer, an intermediate layer, an electron transport layer, a transparent electrode and a metal electrode are sequentially stacked.

### Comparative Example 1: Manufacture of tandem silicon/perovskite heterojunction solar cell

A tandem silicon/perovskite heterojunction solar cell was manufactured by the same method as in Example 1. However, unlike Example 1, the precursor solution used to form the perovskite light-absorbing layer was prepared by dissolving the perovskite material represented by Chemical Formula 1-1 above in a mixed solution including dimethylformamide (DMF) and dimethylpropyleneurea (N,N'-Dimethylpropyleneurea (DMPU).

### Comparative Example 2: Manufacture of tandem silicon/perovskite heterojunction solar cell

A tandem silicon/perovskite heterojunction solar cell was manufactured by the same method as in Example 1. However, unlike Example 1, a precursor solution used to form a perovskite light-absorbing layer was prepared by dissolving the perovskite material represented by Chemical Formula 1-1 above and benzylhydrazine hydrochloride in a mixed solution including dimethylformamide (DMF) and dimethylpropyleneurea (N,N'-Dimethylpropyleneurea (DMPU). In this case, the precursor solution included the perovskite material represented by Chemical Formula 1-1 above and benzylhydrazine hydrochloride in a weight ratio of 1:0.0005.

### Example 2: Manufacture of tandem silicon/perovskite heterojunction solar cell

A tandem silicon/perovskite heterojunction solar cell was manufactured by the same method as in Example 1. However, unlike Example 1, the precursor solution used to form the perovskite light-absorbing layer included the perovskite material represented by Chemical Formula 1-1 and a benzylhydrazine oxalate salt in a weight ratio of 1:0.0002.

### Example 3: Manufacture of tandem silicon/perovskite heterojunction solar cell

A tandem silicon/perovskite heterojunction solar cell was manufactured by the same method as in Example 1. However, unlike Example 1, the precursor solution used to form the perovskite light-absorbing layer included the perovskite material represented by Chemical Formula 1-1 above and a benzylhydrazine oxalate salt in a weight ratio of 1:0.0017.

### Experimental Example 1: Evaluation of performance and long-term storage stability of solar cells

For each of the tandem silicon/perovskite heterojunction solar cells manufactured in Examples 1 to 3 and Comparative Examples 1 to 2, the efficiency was measured by using a solar simulation device and a JV Wavelabs device, and using the initial JV curve. After storing the cells in an atmospheric pressure desiccator for 30 days, the JV curve was measured to measure changes in the solar cell characteristics after aging, and the results are shown in Table 1 below.

**[Table 1]**

| Classification | Aging time (day) | Open-circuit voltage (V_{oc}, V) | Short-circuit current density (J_{sc}, mA/cm²) | Fill factor (FF) | Photoelectric conversion efficiency (%) | Decrease rate (%) |
|---|---|---|---|---|---|---|
| Example 1 | 0 | 1.869 | 19.92 | 77.43 | 28.83 | -0.11 |
| | 30 | 1.867 | 19.97 | 77.23 | 28.79 | |
| Example 2 | 0 | 1.866 | 19.85 | 76.89 | 28.48 | -4.26 |
| | 30 | 1.845 | 19.83 | 74.53 | 27.27 | |
| Example 3 | 0 | 1.868 | 19.78 | 75.18 | 27.78 | -3.06 |
| | 30 | 1.854 | 19.84 | 73.21 | 26.93 | |
| Compara tive Example 1 | 0 | 1.868 | 19.78 | 76.57 | 28.29 | -21.12 |
| | 30 | 1.807 | 18.45 | 66.94 | 22.32 | |
| Compara tive Example 2 | 0 | 1.867 | 19.88 | 77.22 | 28.66 | -0.26 |
| | 30 | 1.862 | 19.92 | 77.07 | 28.59 | |

As can be confirmed in Table 1 above, it was confirmed that the tandem silicon/perovskite heterojunction solar cells manufactured in Examples 1 to 3 had higher long-term storage stability than the tandem silicon/perovskite heterojunction solar cell manufactured in Comparative Example 1.

The above has been illustrated and described with respect to specific embodiments. However, it is not limited to the above-described embodiments, and those skilled in the art to which the invention pertains can make various modifications and implementations without departing from the gist of the technical idea of the invention described in the claims below.

## Claims

1. A tandem silicon/perovskite heterojunction solar cell that is a heterojunction solar cell in which a solar cell, a transparent conductive layer, a hole transport layer, a perovskite light-absorbing layer, an electron transport layer, a transparent electrode and a metal electrode are sequentially stacked,
wherein the perovskite light-absorbing layer comprises a perovskite material represented by Chemical Formula 1 below and a benzylhydrazine oxalate salt:
[Chemical Formula 1] FACsPbX₃
wherein in Chemical Formula 1 above, X is a monovalent anion.

2. The tandem silicon/perovskite heterojunction solar cell of claim 1, wherein the perovskite light-absorbing layer comprises the perovskite material represented by Chemical Formula 1 above and the benzylhydrazine oxalate salt in a weight ratio of 1:0.0001 to 0.002.

3. The tandem silicon/perovskite heterojunction solar cell of claim 1, wherein the perovskite light-absorbing layer has an average thickness of 450 to 700 nm.

4. The tandem silicon/perovskite heterojunction solar cell of claim 1, further comprising:
a first interface layer between the hole transport layer and the perovskite light-absorbing layer.

5. The tandem silicon/perovskite heterojunction solar cell of claim 4, wherein the first interface layer comprises a P-type organic molecule SAM interface coating agent.

6. The tandem silicon/perovskite heterojunction solar cell of claim 4, wherein the first interface layer has a thickness of 0.5 nm to 10 nm.

7. The tandem silicon/perovskite heterojunction solar cell of claim 1, further comprising:
a second interface layer between the perovskite light-absorbing layer and the electron transport layer.

8. The tandem silicon/perovskite heterojunction solar cell of claim 7, wherein the second interface layer comprises one or more selected from lithium fluoride (LiF), magnesium fluoride (MgF₂), cesium fluoride (CsF), sodium fluoride (NaF), potassium fluoride (KF), aluminum fluoride (AlF₃) and calcium fluoride (CaF₂).

9. The tandem silicon/perovskite heterojunction solar cell of claim 7, wherein the second interface layer has a thickness of 0.5 nm to 10 nm.

10. The tandem silicon/perovskite heterojunction solar cell of claim 7, further comprising:
an intermediate layer between the second interface layer and the electron transport layer.

11. The tandem silicon/perovskite heterojunction solar cell of claim 10, wherein the intermediate layer comprises a fullerene-series organic material.

12. A method for manufacturing a tandem silicon/perovskite heterojunction solar cell, the method comprising:
step 1 of sequentially stacking a solar cell, a transparent conductive layer, a hole transport layer and a first interface layer;
step 2 of forming a perovskite light-absorbing layer on the first interface layer through a coating method; and
step 3 of sequentially forming a second interface layer, an intermediate layer, an electron transport layer, a transparent electrode and a metal electrode on the perovskite light-absorbing layer,
wherein the perovskite light-absorbing layer comprises a perovskite material represented by Chemical Formula 1 below and a benzylhydrazine oxalate salt:
[Chemical Formula 1] FACsPbX₃
wherein in Chemical Formula 1 above, X is a monovalent anion.

13. The method of claim 12, wherein the coating method is a gravure coating method, a bar coating method, a printing method, a spray coating method, a spin coating method, a blade coating method, a dip method or a die coat method.

14. The method of claim 12, wherein in the perovskite light-absorbing layer, the perovskite material represented by Chemical Formula 1 above and the benzylhydrazine oxalate are mixed in a weight ratio of 1:0.0001 to 0.002.

15. The method of claim 12, wherein the first interface layer is formed by comprising:
step (1) of heating the hole transport layer;
step (2) of coating a P-type organic molecule SAM interfacial coating agent on a heated hole transport layer; and
step (3) of drying a coated P-type organic molecule SAM interfacial coating agent to form a first interfacial layer.
